Europäisches Patentamt

European Patent Office

Office européen des brevets

(11) Veröffentlichungsnummer: **0 421 004 A1**

## (12) EUROPÄISCHE PATENTANMELDUNG

(21) Anmeldenummer: 89118349.3

(22) Anmeldetag: 03.10.89

(51) Int. Cl.⁵: **H01L 27/02**

(43) Veröffentlichungstag der Anmeldung:
**10.04.91 Patentblatt 91/15**

(84) Benannte Vertragsstaaten:
**DE FR GB IT**

(71) Anmelder: **Siemens Aktiengesellschaft**
**Wittelsbacherplatz 2**
**W-8000 München 2(DE)**

(72) Erfinder: **Hargasser, Hans, Dipl.-Ing. (FH)**
**Salzmannstrasse 46**
**W-8000 München 83(DE)**
Erfinder: **Höltge, Harald, Dipl.-Ing.**
**Birkenleiten 11**
**W-8000 München 90(DE)**

(54) **MOS-Tetrode mit optimiertem Schutz gegen ESD.**

(57) Eine MOS-Tetrode mit Schutzeinrichtungen gegenüber Spannungen an Gate 1 und Gate 2 dieser MOS-Tetrode, wobei jede Schutzeinrichtung nach Überschreiten einer Zündspannung ($U_Z$) einen relativ niederohmigen Zündwiderstand ($r_Z$) aufweist, soll einen optimierten Schutz gegen statische Entladungen besitzen. Die Zündspannung der das Gate 1 schützenden Schutzeinrichtung ist kleiner als die Zündspannung der das Gate 2 schützenden Schutzeinrichtung. Der Zündwiderstand der das Gate 1 schützenden Schutzeinrichtung ist kleiner als der Zündwiderstand der das Gate 2 schützenden Schutzeinrichtung.

EP 0 421 004 A1

## MOS-TETRODE MIT OPTIMIERTEM SCHUTZ GEGEN ESD

Die Erfindung betrifft eine MOS-Tetrode mit Schutzeinrichtungen gegen Überspannungen an den beiden Gates dieser MOS-Tetrode nach dem Oberbegriff des Patentanspruchs 1.

Fernseh-Tuner, insbesondere UHF-Fernseh-Tuner, können über die Antennenzuführung mit Hochspannungsimpulsen belastet werden, die z. B. von atmosphärischen Entladungen herrühren. Dabei können die Schaltelemente eines Tuners einen Teil derjenigen elektrischen Ladung ableiten, die insgesamt an den Eingang des Tuners gelangen kann. Ein Teil der auftreffenden Energie oder der an den Eingang des Tuners gelangenden Ladung wird jedoch durch die Schaltelemente bis zur Eingangselektrode der ersten Verstärkerstufe des Tuners, nämlich bis zur Eingangselektrode (Gate 1) der MOS-Tetrode geführt. Dieser auf die Eingangselektrode der MOS-Tetrode auftreffende Energieanteil kann die MOS-Tetrode zerstören.

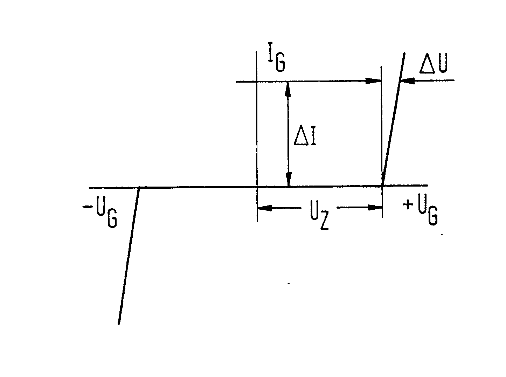

Aus diesem Grund werden MOS-Tetroden an beiden Gates, sowohl am Gate 1 als auch am Gate 2, gegen auftreffende Überspannungen geschützt. Die zum Schutz dieser beiden Gates verwendeten Schutzschaltungen haben üblicherweise die in der Figur gezeigte Charakteristik. Dabei sind folgende Bezeichnungen verwendet:

$U_Z$ = Zündspannung einer ein Gate der MOS-Tetrode schützenden Schutzschaltung

$U_G$ = die jeweils am Gate 1 bzw. am Gate 2 der MOS-Tetrode anliegende Spannung

$I_G$ = in den jeweiligen Gate-Anschluß der MOS-Tetrode fließender Strom

Als Quotient der in der Figur gezeigten Größen $\Delta U$ und $\Delta I$ ergibt sich der Zündwiderstand $r_Z$ der das jeweilige Gate der MOS-Tetrode schützenden Schutzschaltung nach folgender Gleichung:

$r_Z = \frac{\Delta U}{\Delta I}$.

Die Figur zeigt, daß die das jeweilige Gate der MOS-Tetrode schützenden Schutzelemente nach Überschreiten der Zündspannung $U_Z$ durch die am jeweiligen Gate anliegende Spannung $U_G$ sowohl mit positiver als auch mit negativer Polarität relativ niederohmig werden, und daß die am jeweiligen Gate der MOS-Tetrode anliegende Spannung $U_G$ nach Überschreiten dieser Zündspannung $U_Z$ nur noch mit dem Spannungsabfall am Zündwiderstand $r_Z$ des jeweiligen Schutzelementes ansteigt. Überschreitet dabei nach Überschreiten der Zündspannung $U_Z$ die am jeweiligen Gate der MOS-Tetrode anliegende Spannung $U_G$ entweder mit positiver oder mit negativer Polarität die Oxid-Durchbruchspannung eines Gates der MOS-Tetrode, so wird die MOS-Tetrode irreversibel beschädigt.

Die bis heute bekannt gewordenen technischen Lösungen sehen entweder sowohl für Gate 1 als auch für Gate 2 einer MOS-Tetrode gleichartige und gleichwertige Schutzelemente vor oder sie sehen für Gate 1 und Gate 2 einer MOS-Tetrode unterschiedliche Schutzelemente vor, wobei im letzteren Fall das Schutzelement für Gate 1 hinsichtlich der Kapazität C optimiert wurde. Dabei bedeutet eine Optimierung bezüglich der Kapazität C, daß die Kapazität des Schutzelementes, welche zur Eingangskapazität der MOS-Tetrode beiträgt, minimiert wird und ein technisch bedingtes Ansteigen des Zündwiderstandes $r_Z$ des das Gate 1 der MOS-Tetrode schützenden Schutzelements zu Gunsten der Eingangskapazität und zum Nachteil der ESD (ESD = Electro Static Discharge)-Festigkeit hingenommen wird.

Ein weiteres Merkmal der bestehenden technischen Lösungen ist, daß die Zündspannung $U_Z$ der beiden Schutzelemente sowohl für Gate 1 als auch für Gate 2 der MOS-Tetrode gleich groß gewählt wird.

Der vorliegenden Erfindung liegt die Aufgabe zugrunde, eine MOS-Tetrode der eingangs genannten Art anzugeben, die einen optimierten Schutz gegen statische Entladungen aufweist.

Diese Aufgabe wird erfindungsgemäß durch eine MOS-Tetrode nach Patentanspruch 1 gelöst.

Ausgestaltungen und Vorteile der Erfindung sind in den Unteransprüchen, der Beschreibung und der Zeichnung angegeben.

Eine MOS-Tetrode nach der Erfindung ist wirksam gegen Überspannungen geschützt, die zu einer Zerstörung der MOS-Tetrode führen würden.

Der Zündwiderstand $r_Z$ ist ein Maß für die Wirksamkeit eines Schutzelements. Im Stabilisierungsbereich (nach Überschreiten der Zündspannung $U_Z$) hat die Kennlinie eines ein Gate der MOS-Tetrode schützenden Schutzelements einen sehr steilen Verlauf. Das Steigungsmaß dieser Kennlinie gibt die Größe des Zündwiderstands $r_Z$ an. Dieses Steigungsmaß sollte möglichst klein sein, damit eine gute Spannungsstabilisierung erreicht wird.

Der Zündwiderstand $r_Z$ kann reduziert werden, wenn gleichzeitig auch eine niedrigere Zündspannung $U_Z$ akzeptiert wird. Ein sclcher Zusammenhang ist beispielsweise aus der europäischen Patentschrift EP-B-0 003 130 ersichtlich.

Die Erfindung wird im folgenden näher erläutert.

Die Figur erläutert eine Kennlinie einer ein Gate der MOS-Tetrode schützenden Schutzschaltung.

An der jeweiligen Schutzschaltung liegt dieselbe Spannung an wie am jeweiligen Gate der MOS-Tetrode, das durch diese jeweilige Schutzschaltung geschützt wird. Als Schutzschaltung kann jede Schaltung verwendet werden, die der Fachmann als geeignet erkennt. Als Schutzschaltung kann insbesondere jede Schutzdiode verwendet werden, die der Fachmann als geeignet erkennt. In einer Schutzschaltung bzw. als Schutzelemente können solche Dioden Verwendung finden, die bei einem Betrieb in Sperrichtung nach Erreichen der Durchbruchspannung einen möglichst steilen Verlauf ihrer Kennlinie aufweisen. Steile Kennlinien-Verläufe sowohl für positive als auch für negative Polarität können durch back-to-back-Hintereinanderschalten zweier Dioden erzielt werden.

Eine MOS-Tetrode kann zusammen mit Teilen der Schutzeinrichtungen oder zusammen mit den gesamten Schutzeinrichtungen in integrierter Form hergestellt werden. Eine MOS-Tetrode kann jedoch auch in diskreter Form zusammen mit Schutzeinrichtungen in einem Tuner oder in einer sonstigen Schaltung zusammengeschaltet sein.

Für Schutzschaltungen nach der Erfindung können Halbleiterbauelemente Verwendung finden, die den Zener-Effekt, den Avalanche-oder den Punch-through-Effekt ausnutzen.

Schutzschaltungen können insbesondere zwischen dem jeweiligen Gate und der Source-Elektrode der MOS-Tetrode geschaltet sein.

Aus technischen Gründen ist für die Schutzschaltung zum Schutz von Gate 2 der MOS-Tetrode eine Zündspannung $U_Z$ von größer 9 V, typisch 10-11 V, günstig, im Hinblick auf die heute üblichen Regelschaltungen. Im Gegensatz dazu kann für das Gate 1 der MOS-Tetrode die Zündspannung $U_Z$ deutlich kleiner gewählt und kann damit die ESD-Festigkeit der am meisten gefährdeten Steuerelektrode, nämlich des Gate 1, deutlich gesteigert werden.

Für die Schutzschaltung zum Schutz von Gate 1 kann z. B. eine Zündspannung $U_Z$ verwendet werden, die nur etwas größer ist als 6 V, was beispielsweise etwa eine Halbierung des Zündwiderstands $r_Z$ im Vergleich zu demjenigen Zündwiderstand bedeutet, der sich für eine Zündspannung $U_Z$ von etwa 10 V ergibt.

Bei einer Zündspannung von 6,2 V für Gate 1 und 10 V für Gate 2 kann der Zündwiderstand für die Schutzschaltung für Gate 1 den halben Wert des Zündwiderstands der Schutzschaltung für Gate 2 aufweisen.

Bei einer Zündspannung für Gate 1 von 8,2 V und bei einer Zündspannung für Gate 2 von 10 V kann das Verhältnis vom Wert des Zündwiderstands für die Schutzschaltung von Gate 1 zum Wert des Zündwiderstands für die Schutzschaltung von Gate 2 den Wert von 4,5/7 aufweisen und damit zwischen 0,55 und 0, 75 liegen.

Für die Schutzschaltung von Gate 1 ist auch eine Zündspannung von unterhalb von 6 V geeignet, wenn dort der Zündwiderstand ausreichend klein ist.

Die Zündspannung der Schutzschaltung von Gate 1 kann auch nur knapp unterhalb der Zündspannung der Schutzschaltung von Gate 2 liegen. Dabei kann es bereits vorteilhaft sein, wenn das Verhältnis vom Wert des Zündwiderstands der Schutzschaltung von Gate 1 zum Wert des Zündwiderstands der Schutzschaltung von Gate 2 größer als 0,75, jedoch kleiner als 1 ist.

Die Erfindung ermöglicht gleichzeitig die Ableitung von großen Überspannungen und gleichzeitig den Schutz der MOS-Tetrode vor einer irreversiblen Zerstörung dieser MOS-Tetrode und gleichzeitig eine Verwendung der MOS-Tetrode für hohe Frequenzen und gleichzeitig die Verwendung einer Regelschaltung für die Ansteuerung von Gate 2.

## Ansprüche

1. MOS-Tetrode mit Schutzeinrichtungen gegen Überspannungen an Gate 1 und Gate 2 dieser MOS-Tetrode, wobei jede Schutzeinrichtung nach Überschreiten einer Zündspannung ($U_Z$) einen relativ niederohmigen Zündwiderstand ($r_Z$) aufweist, **dadurch gekennzeichnet,** daß die Zündspannung der das Gate 1 schützenden Schutzeinrichtung kleiner ist als die Zündspannung der das Gate 2 schützenden Schutzeinrichtung, und daß der Zündwiderstand der das Gate 1 schützenden Schutzeinrichtung kleiner ist als der Zündwiderstand der das Gate 2 schützenden Schutzeinrichtung.

2. MOS-Tetrode nach Anspruch 1, **dadurch gekennzeichnet,** daß der Wert des Zündwiderstands der Gate 1 schützenden Schutzeinrichtung weniger als 75 % des Wertes des Zündwiderstands der das Gate 2 schützenden Schutzeinrichtung beträgt.

3. MOS-Tetrode nach Anspruch 1 oder 2, **dadurch gekennzeichnet,** daß der Wert des Zündwiderstands der das Gate 1 schützenden Schutzeinrichtung weniger als 55 % des Werts des Zündwiderstands der das Gate 2 schützenden Schutzeinrichtung beträgt.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5 ) |
|---|---|---|---|
| Y | PATENT ABSTRACTS OF JAPAN vol. 12, no. 330 (E-655)(3177) 07 September 1988, & JP-A-63 95668 (NEC) 26 April 1988, * das ganze Dokument * | 1 | H01L27/02 |
| A | --- | 2, 3 | |
| Y | SIEMENS UND HALSKE: "HALBLEITER-DATENBUCH 1961" 1962, BERLIN, DEUTSCHLAND * Seite 127 * | 1 | |
| A | --- PATENT ABSTRACTS OF JAPAN vol. 8, no. 235 (E-275)(1672) 27 Oktober 1984, & JP-A-59 117165 (NIPPON DENKI) 06 Juli 1984, * das ganze Dokument * ----- | 1 | |

**RECHERCHIERTE SACHGEBIETE (Int. Cl.5 )**

H01L

Der vorliegende Recherchenbericht wurde für alle Patentansprüche erstellt

| Recherchenort | Abschlußdatum der Recherche | Prüfer |
|---|---|---|
| DEN HAAG | 18 MAI 1990 | VENDANGE P. |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes
    Dokument

EPO FORM 1503 03.82 (P0403)